# EUROPEAN PATENT APPLICATION

(11) **EP 2 693 488 A1**
(43) Date of publication of application: **05.02.2014**
(21) Application number: 12765597.5
(22) Date of filing: 29.02.2012
(51) Int. Cl.: H01L 31/04

(54) **PHOTOELECTRIC CONVERSION DEVICE AND METHOD FOR PRODUCING SAME**

(30) Priority: 28.03.2011 JP 2011069678
(71) Applicant: Sanyo Electric Co., Ltd., Osaka 570-8677 (JP)
(72) Inventor: GOTO, Ryo, Chuo-ku, Osaka 540-6207 (JP); HASHIGUCHI, Taiki, Chuo-ku, Osaka 540-6207 (JP); FUJITA, Kazunori, Chuo-ku, Osaka 540-6207 (JP); SHIGEMATSU, Masato, Chuo-ku, Osaka 540-6207 (JP); KIRIHATA, Yutaka, Chuo-ku, Osaka 540-6207 (JP); MISHIMA, Takahiro, Chuo-ku, Osaka 540-6207 (JP)
(74) Representative: Klunker . Schmitt-Nilson . Hirsch
(86) International application number: PCT/JP2012/055076
(87) International publication number: WO 2012/132729

(57) **Abstract**

A photovoltaic device (10) is provided with: an n-type monocrystalline silicon substrate (21); an IN layer (25) layered over one surface of the n-type monocrystalline silicon substrate (21); an IP layer (26) layered over a region, of one surface of the IN layer 25, where the IN layer (25) is not layered, and layered so as to have an overlap region (26*) which is overlapped with the region where the IN layer (25) is layered; an n-side electrode (40) electrically connected to the IN layer (25) and formed over the overlap region (26*); and a p-side electrode (50) formed distanced from the n-side electrode (40) and electrically connected to the IP layer (26). In the IP layer (26), a separation gap (60) is formed between a region where the n-side electrode (40) is formed and a region where the p-side electrode (50) is formed.

## Description

### TECHNICAL FIELD

The present invention relates to a photovoltaic device and a production method thereof.

### BACKGROUND ART

Patent Document 1 proposes a solar cell of a back contact type in which a p-type semiconductor region, a p-side electrode, an n-type semiconductor region, and an n-side electrode are formed on a back surface side of the solar cell. With such a back contact type solar cell, because there is no electrode on the light-receiving surface side, a light-receiving efficiency of the solar light can be improved and the power generation efficiency can consequently be improved.

### [Related Art References]

### [Patent Document]

[Patent Document 1] JP 2009-200267 A

### DISCLOSURE OF INVENTION

### [Technical Problem]

However, for the solar cell of the back contact type, there still is a room for improvement from various viewpoints, such as improvement in photovoltaic efficiency. Among several improvements to be made, improvement in insulation between the p-type semiconductor region and p-side electrode, and the n-type semiconductor region and n-side electrode, in order to reduce a leak current, is particularly important.

The present invention was conceived in view of the above-described circumstances, and an advantage of the present invention lies in provision of a photovoltaic device which can reduce leak current, and a production method thereof.

### [Solution to Problem]

According to one aspect of the present invention, there is provided a photovoltaic device comprising a crystalline semiconductor substrate; a first amorphous semiconductor layer which is layered over one surface of the crystalline semiconductor substrate; a second amorphous semiconductor layer which is layered over a region, of the one surface of the crystalline semiconductor substrate, where the first amorphous semiconductor layer is not layered, which is layered so as to have an overlap region which is overlapped with the region where the first amorphous semiconductor layer is layered, and which includes a layer of an opposite conductive type as that of the first amorphous semiconductor layer; a first electrode which is electrically connected to the first amorphous semiconductor layer and which is formed over the overlap region of the second amorphous semiconductor layer; and a second electrode which is formed distanced from the first electrode and electrically connected to the second amorphous semiconductor layer, wherein the second amorphous semiconductor layer has a separation gap or a thin film region where a thickness is thinner than other regions, between a region where the first electrode is formed and a region where the second electrode is formed.

According to another aspect of the present invention, there is provided a method of producing a photovoltaic device, comprising a step of layering a first amorphous semiconductor layer over one surface of a crystalline semiconductor substrate; a step of layering a second amorphous semiconductor layer over a region, of the one surface of the crystalline semiconductor substrate, where the first amorphous semiconductor layer is not layered, and over a part of a region where the first amorphous semiconductor layer is layered, the second amorphous semiconductor layer including a layer of an opposite conductive type as that of the first amorphous semiconductor layer; an electrode forming step in which a first electrode is formed over the first amorphous semiconductor layer and over an overlap region of the second amorphous semiconductor layer overlapped with the first amorphous semiconductor layer, and a second electrode is formed over the second amorphous semiconductor layer distanced from the first electrode; and a removal step in which at least a part of the second amorphous semiconductor layer which exists between the first electrode and the second electrode is removed.

### [Advantageous Effects of Invention]

According to various aspects of the present invention, in a photovoltaic device, leak current can be reduced and photovoltaic efficiency can be further improved.

### BRIEF DESCRIPTION OF DRAWINGS

FIG. 1 is a plan view of a photovoltaic device according to a preferred embodiment of the present invention, as viewed from a back surface side.
FIG. 2 is a cross sectional diagram along an A-A line of FIG. 1.
FIG. 3 is an enlarged view of a B part of FIG. 2.
FIG. 4 is a diagram omitting the showing of an n-side electrode and a p-side electrode in FIG. 1 and showing a planar shape pattern of an IN amorphous silicon layer and an IP amorphous silicon layer.
FIG. 5 is a cross sectional diagram for explaining a method of producing a photovoltaic device according to a preferred embodiment of the present invention, and shows a production step of an intermediate product (a photovoltaic unit in which the separation gap is incomplete).
FIG. 6 is a cross sectional diagram for explaining a method of producing a photovoltaic device according to a preferred embodiment of the present invention, and shows a production step of an intermediate product.
FIG. 7 is a cross sectional diagram for explaining a method of producing a photovoltaic device according to a preferred embodiment of the present invention, and shows a production step of an intermediate product.
FIG. 8 is a cross sectional diagram for explaining a method of producing a photovoltaic device according to a preferred embodiment of the present invention, and shows a production step of an intermediate product.
FIG. 9 is a cross sectional diagram for explaining a method of producing a photovoltaic device according to a preferred embodiment of the present invention, and shows formation steps of first and second conductive layers which form electrodes.
FIG. 10 is a cross sectional diagram for explaining a method of producing a photovoltaic device according to a preferred embodiment of the present invention, and shows formation steps of first and second conductive layers which form electrodes.
FIG. 11 is a cross sectional diagram for explaining a method of producing a photovoltaic device according to a preferred embodiment of the present invention, and shows an etching step of an IP amorphous silicon layer.
FIG. 12 is a cross sectional diagram for explaining a method of producing a photovoltaic device according to a preferred embodiment of the present invention, and shows a formation step of a third conductive layer which forms electrodes.

### BEST MODE FOR CARRYING OUT THE INVENTION

A preferred embodiment of the present invention will now be described in detail with reference to the drawings. The below-described preferred embodiment is merely exemplary, and the present invention is not limited to the preferred embodiment described below. In addition, the drawings referred to in the preferred embodiment are drawn schematically, and the size ratios of the structures drawn in the drawings or the like may differ from the size ratios of the actual structures. The specific size ratios of the actually structures or the like should be determined in consideration of the following description.

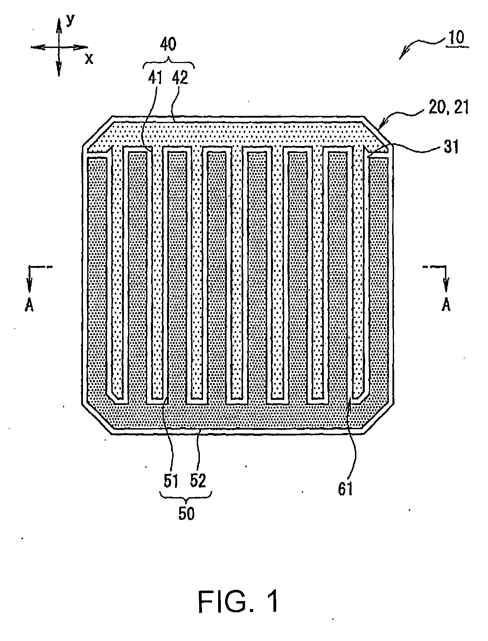

First, with reference to FIGs. 1 - 4, a structure of a photovoltaic device 10 will be described in detail.

FIG. 1 is a plan view of the photovoltaic device 10 as viewed from the back surface side. In FIG. 1, in order to clarify the drawing, dots with a low density are shown in a region where an n-side electrode 40 is formed and dots of a high density are shown in a region where a p-side electrode 50 is formed. As shown in FIG. 1, the photovoltaic device 10 comprises a photovoltaic unit 20 which generates carriers (electrons and holes) by receiving light such as solar light, and the n-side electrode 40 and the p-side electrode 50 formed on the back surface side of the photovoltaic unit 20. In the photovoltaic device 10, carriers generated in the photovoltaic unit 20 are collected by the n-side electrode 40 and the p-side electrode 50, respectively. Line members (not shown) are electrically connected to the n-side electrode 40 and the p-side electrode 50 to form a module of the photovoltaic device 10, so that carriers are extracted to the outside as electrical energy.

Here, the "back surface" refers to a surface which is on the opposite side from the "light-receiving surface" on which light is incident from the outside of the device. In other words, the surface on which the n-side electrode 40 and the p-side electrode 50 are formed is the back surface. The n-side electrode 40 is an electrode which collects carriers (electrons) from an IN amorphous silicon layer 25 of the photovoltaic unit 20. The p-side electrode 50 is an electrode which collects carriers (holes) from an IP amorphous silicon layer 26 of the photovoltaic unit 20. Each of the electrodes preferably comprises a plurality of finger electrode sections 41 and 51 and bus bar electrode sections 42 and 52 connecting the corresponding finger electrode sections, respectively.

The photovoltaic unit 20 comprises an n-type monocrystalline silicon substrate 21 which is a crystalline semiconductor substrate of an approximate square shape. As the crystalline semiconductor substrate, for example, an n-type polycrystalline silicon substrate or a p-type monocrystalline or polycrystalline silicon substrate may be employed, and the crystalline semiconductor substrate is preferably the n-type monocrystalline silicon substrate 21 exemplified in the present embodiment.

The n-type monocrystalline silicon substrate 21 functions as a power generation layer, and has a thickness of, for example, 100 µm - 300 µm. On the light-receiving surface of the n-type monocrystalline silicon substrate 21, a texture structure (not shown) is preferably formed. Here, the "texture structure" refers to a projection-and-recess structure which inhibits surface reflection and increases an amount of light absorption by the photovoltaic unit 20. Specific examples of the texture structure include a projection-and-recess structure having a pyramid shape (rectangular cone or rectangular prismoid) obtained by applying anisotropic etching on the light-receiving surface having a (100) plane.

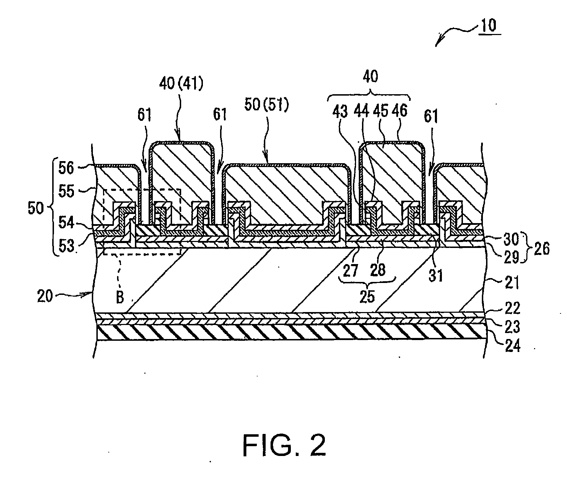

FIG. 2 is a cross sectional diagram along a line A-A in FIG. 1; that is, a cross sectional diagram cutting the finger electrode sections 41 and 51 in the width direction. As shown in FIG. 2, on the light-receiving surface side of the n-type monocrystalline silicon substrate 21, for example, an i-type amorphous silicon film 22, an n-type amorphous silicon layer 23, and a protection layer 24 are preferably formed in order. Here, the i-type amorphous silicon layer 22 and the n-type amorphous silicon layer 23 function as passivation layers. The protection layer 24 protects the passivation layer and also has a reflection prevention function.

The i-type amorphous silicon layer 22 and the n-type amorphous silicon layer 23 are preferably formed, for example, over the entire region of the light-receiving surface of the n-type monocrystalline silicon substrate 21 other than an end edge region. The i-type amorphous silicon layer 22 is a thin film layer of intrinsic amorphous silicon, and has a thickness of, for example, about 0.1 nm - 25 nm. The n-type amorphous silicon layer 23 is, for example, a thin film layer of amorphous silicon doped with phosphorus (P) or the like, and has a thickness of about 2 nm - 50 nm.

The protection layer 24 is preferably layered over approximately the entire region over the n-type amorphous silicon layer 23. The protection layer 24 is preferably formed with a material having a high level of light transmittance, and is, for example, preferably an insulating layer made of silicon oxide (SiO₂), silicon nitride (SiN), silicon oxynitride (SiON), or the like. Of these, the SiN layer is particularly preferable. A thickness of the protection layer 24 can be arbitrarily changed in consideration of the reflection prevention characteristic or the like, but preferably is 80 nm - 1 µm, for example.

In the photovoltaic unit 20, on the back surface side of the n-type monocrystalline silicon substrate 21, for example, the IN amorphous silicon layer 25 (hereinafter simply referred to as "IN layer 25") which is a first amorphous semiconductor layer, the IP amorphous silicon layer 26 (hereinafter simply referred to as "IP layer 26") which is a second amorphous semiconductor layer, and an insulating layer 31 are layered. Most of the IN layer 25 and the IP layer 26 are directly layered over the back surface of the n-type monocrystalline silicon substrate 21. On the other hand, the insulating layer 31 is layered over a part of the IN layer 25.

The IN layer 25 preferably comprises an i-type amorphous silicon layer 27 layered over the back surface of the n-type monocrystalline silicon substrate 21, and an n-type amorphous silicon layer 28 layered over the i-type amorphous silicon layer 27. The i-type amorphous silicon layer 27 and the n-type amorphous silicon layer 28 can each be formed, for example, with compositions and thicknesses similar to those of the i-type amorphous silicon layer 22 and the n-type amorphous silicon layer 23, respectively.

The IP layer 26 preferably comprises an i-type amorphous silicon layer 29 which is layered primarily over the back surface of the n-type monocrystalline silicon substrate 21, and a p-type amorphous silicon layer 30 which is layered over the i-type amorphous silicon layer 29. The i-type amorphous silicon layer 29 can be formed, for example, with a composition and a thickness similar to those of the i-type amorphous silicon layer 22 and the i-type amorphous silicon layer 27. On the other hand, the p-type amorphous silicon layer 30 is preferably a thin film layer of amorphous silicon doped with, for example, boron (B) or the like. A thickness of the p-type amorphous silicon layer 30 is preferably about 2 nm - 50 nm, for example.

The IN layer 25 and the IP layer 26 are preferably alternately and repeatedly layered along one direction, from the viewpoint of the photovoltaic efficiency or the like. In addition, the IN layer 25 and the IP layer 26 are preferably layered over a wide range over the back surface of the n-type monocrystalline silicon substrate 21. Because of this, there is preferably employed a configuration in which a part of the IN layer 25 and a part of the IP layer 26 are overlapped with each other; for example, one layer is overlapped with the other layer and layered without a gap. In addition, such layering is also preferable from the viewpoint of productivity.

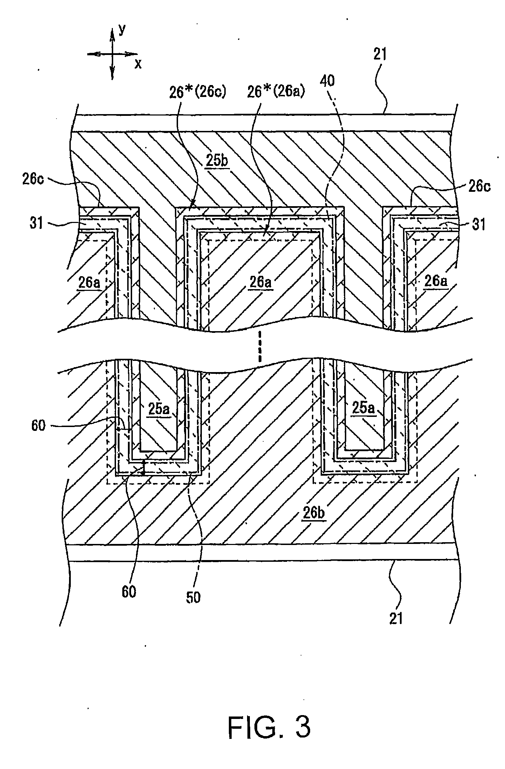

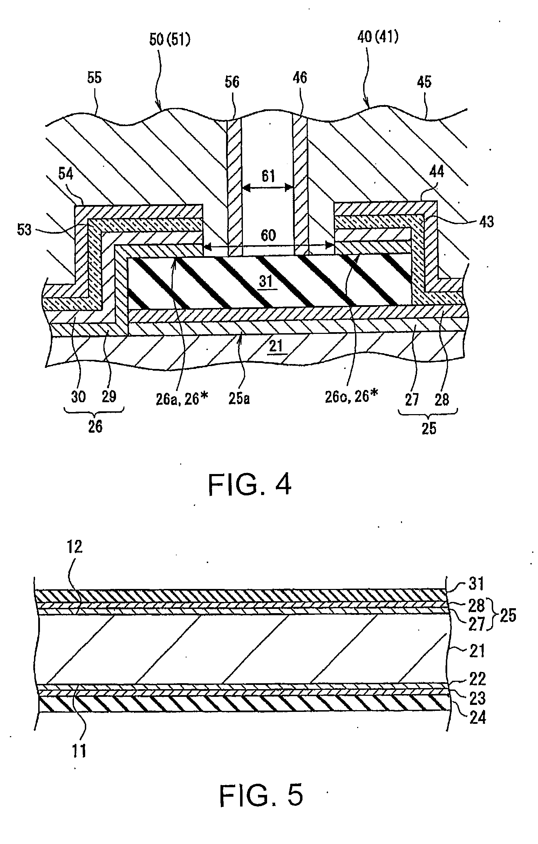

In the following description, a configuration is exemplified in which the IP layer 26 is overlapped with and layered over the IN layer 25. A region of the IP layer 26 in which the IP layer 26 is overlapped with and layered over the IN layer 25 will be referred to as an "overlap region 26*" (refer to FIGs. 3 and 4). A direction in which the IN layer 25 and the IP layer 26 are alternately and repeatedly formed will be referred to as an "x direction," and a direction orthogonal to the x direction will be referred to as a "y direction."

The insulating layer 31 is preferably provided in at least a part of a region between the IN layer 25 and the overlap region 26* of the IP layer 26. The insulating layer 31 has a function to improve the insulation between the IN layer 25 and the IP layer 26. The insulating layer 31 can be formed with a composition and a thickness similar to those of the protection layer 24, and, for example, a SiN layer is preferable.

It is particularly preferable that the insulating layer 31 is formed over the entire region over the IN layer 25 where the IP layer 26 is layered. In other words, the IP layer 26 is not directly layered over the IN layer 25, and is only layered over the insulating layer 31. On the other hand, in the IN layer 25, in the region where the IP layer 26 is not layered, the insulating layer 31 is preferably not layered. With such a structure, an electrical connection between the IN layer 25 and the n-side electrode 40 can be enabled while securing superior insulation between the IN layer 25 and the IP layer 26.

In the following, a configuration will be described in which the insulating layer 31 exists over the entire region of the overlap region 26*, between the overlap region 26* and the IN layer 25.

In the photovoltaic device 10, the n-side electrode 40 is directly formed over the IN layer 25. However, because there exists the overlap region 26* over the IN layer 25, the n-side electrode 40 is also formed over the overlap region 26* . In other words, in order to widen the electrode area and from the viewpoint of simplifying the production process or the like, the n-side electrode 40 is also formed over the overlap region 26* to some extent. With regard to the p-side electrode also, the p-side electrode 50 is preferably formed over a wide range over the IP layer 26 and is preferably formed over the overlap region 26*.

In a region between the n-side electrode 40 and the p-side electrode 50, a separation channel 61 for separating these electrodes is formed. The separation channel 61 is formed over the IP layer 26. The separation channel 61 may be formed in a region near the overlap region 26*, for example, but from the viewpoint of the insulation or the like, the separation channel 61 is preferably formed over the overlap region 26* . More preferably, the separation channel 61 is formed along the overlap region 26*.

The n-side electrode 40 and the p-side electrode 50 (finger electrode section and bus bar electrode section) are preferably formed in a layered structure including, for example, first conductive layers 43 and 53, second conductive layers 44 and 54, third conductive layers 45 and 55, and fourth conductive layers 46 and 56, respectively. The second through fourth conductive layers are preferably metal layers. For example, the second conductive layers 44 and 54 may be set as seed layers forming a starting point for plating growth, and the third conductive layers 45 and 55 and the fourth conductive layers 46 and 56 may be formed through electroplating. On the other hand, the first conductive layers 43 and 53 are preferably transparent conductive layers (TCO films). The transparent conductive layer has a function to prevent contact between the photovoltaic unit 20 and the metal layer, and to improve reflectivity by interaction with the metal layer.

The transparent conductive layer (TCO film) is preferably formed to include at least one of, for example, metal oxides having a polycrystalline structure such as indium oxide (In₂O₃), zinc oxide (ZnO), tin oxide (SnO₂), and titanium oxide (TiO₂). These metal oxides may be doped with a dopant such as tin (Sn), zinc (Zn), tungsten (W), antimony (Sb), titanium (Ti), aluminum (Al), cerium (Ce), and gallium (Ga). For example, ITO in which Sn is doped into In₂O₃ is particularly preferable. A concentration of the dopant may be 0 wt% - 20 wt%. A thickness of the transparent conductive layer is preferably about 50 nm - 100 nm, for example.

The second through fourth conductive layer are preferablymade of metals having high electrical conductivity and high reflectance of light. Examples of metals forming these layers include metals such as silver (Ag), aluminum (Al), titanium (Ti), copper (Cu), and tin (Sn), and alloys including one or more of these metals. For example, the second conductive layers 44 and 54 and the third conductive layers 45 and 55 are preferably Cu layers and the fourth conductive layers 46 and 56 are preferably Sn layers. In this case, the Sn layer functions as a protection layer for the Cu layer. A thickness of the Cu layer is preferably about 10 µm - 20 µm, for example. A thickness of the Sn layer is preferably about 1 µm - 5 µm.

Referring now to FIGs. 3 and 4, the structures of the IN layer 25 and the IP layer 26, in particular, a structure of a boundary region between the IN layer 25 and the IP layer 26 will be described.

FIG. 3 is a diagram in which the n-side electrode 40 and the p-side electrode 50 are omitted from FIG. 1, and shows a planar shape pattern of the IN layer 25 and the IP layer 26. In FIG. 3, for clarity of the drawing, a part of the structure is enlarged. In addition, layered regions in which the IN layer 25 and the IP layer 26 are exposed, respectively, are shown with solid line hatchings with different angles from each other, and a layered region of the IN layer 25 covered by the insulating layer 31 is shown with a broken line hatching. A region shown with a cross hatching is a region where the IN layer 25 and the IP layer 26 overlap; that is, the overlap region 26*. FIG. 4 is a B-part enlarged diagram of FIG. 2; that is, a diagram enlarging and showing the boundary region between the IN layer 25 and the IP layer 26 and a region near the boundary region.

As shown in FIGs. 3 and 4, the IN layer 25 and the IP layer 26 have layering configurations of, for example, a comb shape or a stripe shape in which the layers are formed to interdigitate with each other. The IN layer 25 and the IP layer 26 are preferably layered, for example, alternately and repeatedly along the x direction. In addition, the IN layer 25 and the IP layer 26 are preferably layered without a gap and while forming the overlap region 26*.

The IN layer 25 can be patterned, for example, to have a plurality of IN regions 25a extending along the y direction and an IN region 25b intersecting the IN regions 25a and connecting the IN regions 25a. The IN regions 25a are preferably formed, for example, with a predetermined spacing therebetween along the x direction and parallel to each other.

Similar to the IN layer 25, the IP layer 26 can be patterned to have a plurality of IP regions 26a extending along the y direction and an IP region 26b intersecting the IP regions 26a and connecting the IP regions 26a. In addition, the IP layer 26 preferably has an IP region 26c which is a third region formed, for example, bordering an exposed region of the IN layer 25.

Similar to the IN region 25a, a plurality of the IP regions 26a are preferably formed with a predetermined spacing therebetween in the x direction and parallel to each other. By layering the IP regions 26a to fill in the region between the IN regions 25a, there can be obtained the above-described layered configuration in which the IN layer 25 (IN region 25a) and the IP layer 26 (IP region 26a) are alternately repeated along the x direction. In addition, the x direction end edge region of the IP region 26a is overlapped with and layered over the x direction end edge region of the IN region 25a, so that a plurality of overlap regions 26* are formed in the x direction.

For example, the finger electrode section 41 of the n-side electrode 40 is formed over the exposed region of the IN region 25a, the bus bar electrode section 42 is formed over the exposed region of the IN region 25b, and the electrode sections are also formed over the overlap region 26*. With regard to the p-side electrode 50, for example, the finger electrode section 51 is formed over the IP region 26a, the bus bar electrode section 52 is formed over the IP region 26b, and the electrode sections are also formed over the overlap region 26*.

The IN layer 25 and the IP layer 26 are preferably layered with no gap over the back surface of the n-type monocrystalline silicon substrate 21 also in the y direction. For example, in the boundary region between the IN layer 25 and the IP layer 26 in the y direction, a part of the IP layer 26 is preferably layered overlapped with a part of the IN layer 25. In other words, the IN layer 25 and the IP layer 26 can be layered over the entire region over the back surface of the n-type monocrystalline silicon substrate 21.

The IN layer 25 and the IP layer 26 are preferably layered without a gap, for example, over the entire region other than an end edge region over the back surface of the n-type monocrystalline silicon substrate 21. In other words, the overlap region 26* of the IP layer 26 is preferably formed along the boundary region between the IN layer 25 and the IP layer 26. For example, the overlap region 26* is preferably a region extending in the x direction while repeatedly projecting and recessing in the y direction along the boundary region between the IN regions 25a and 25b and the IP regions 26a and 26b corresponding to the above-described comb-shape pattern.

A width of the overlap region 26* is not particularly limited, and is preferably, for example, 30 µm - 500 µm and about 1/3 of a width of the IN region 25a. A width of the IN region 25a is not particularly limited, and is preferably about 100 µm - 1.5 mm. The spacing of the IN regions 25a may be set larger than the width, and a width of the IP region 26a is set, for example, larger than the width of the IN region 25a. Widths of the IN region 25b and the IP region 26b can be set, for example, larger than the width of the IP region 26a.

On the IP layer 26 including the overlap region 26*, there is preferably formed a separation gap 60 which separates a region where the n-side electrode 40 is formed and a region where the p-side electrode 50 is formed. Alternatively, in the IP layer 26, a thin film region having a thinner thickness of the layer than the other regions is preferably formed between the region where the n-side electrode 40 is formed and the region in which the p-side electrode 50 is formed.

Examples of the thin film region include, for example, a region in which the p-type amorphous silicon layer 30 of the IP layer 26 is thinned by an etching process and a region in which the p-type amorphous silicon layer 30 at an upper layer is removed and the i-type amorphous silicon layer 29 at a lower layer is left.

The IP layer 26 preferably does not have the p-type amorphous silicon layer 30 between the region where the n-side electrode 40 is formed and the region where the p-side electrode 50 is formed. More preferably, as described above, the separation gap 60 is formed and the IP layer 26 connecting the regions is substantially removed or completely removed. The form of the separation gap 60 is not particularly limited, and the separation gap 60 is preferably, for example, a slit or a cutout which extends in a line shape.

The separation gap 60 may be formed, for example, in a region near the overlap region 26*, but from the viewpoint of the insulation and the passivation characteristic, the separation gap 60 is preferably formed in a range of the overlap region 26*. Because the insulating layer 31 exists between the overlap region 26* and the IN layer 25, when the separation gap 60 is formed in the overlap region 26*, the layer to be exposed is the insulating layer 31. In other words, the bottom of the separation gap 60 is the insulating layer 31, and the IN layer 25 is not exposed.

The separation gap 60 is formed, for example, along a part (for example, y direction) of the overlap region 26*. More preferably, the separation gap 60 is formed over the entire length of the overlap region 26*. The overlap region 26* of the IP layer 26 preferably comprises two regions separated by the separation gap 60.

In the present embodiment, with the separation gap 60, the overlap region 26* of the IP layer 26 is separated into IP regions 26a and 26b where the p-side electrode 50 is formed and the IP region 26c where the n-side electrode 40 is formed. The IP region 26c is formed, for example, with a narrower width than the separation gap 60, bordering the exposed region of the IN layer 25.

The separation gap 60 is also preferably formed matching the position of the separation channel 61 which separates each electrode. The separation gap 60 is particularly preferably formed along the separation channel 61 and along the entire length thereof. The formation positions and widths of the separation gap 60 and the separation channel 61 can be arbitrarily adjusted, for example, in an etching step to be described later. The width of the separation channel 61 is preferably narrow within a range in which the insulation can be secured, and is preferably 10 µm - 200 µm, for example. The width of the separation gap 60 is not particularly limited, but is preferably about 1/3 of the width of the overlap region 26*, for example.

In the present embodiment, the width of the separation channel 61 is narrower than the width of the separation gap 60, and the third and fourth conductive layers (45, 46, 55, and 56) of the electrodes exist to fill in a part of the separation gap 60. On the other hand, the gap between the first and second conductive layers (43 and 44) of the n-side electrode 40 and the first and second conductive layers (53 and 54) of the p-side electrode 50 is similar in width to the separation gap 60. This is due to the production process to be described later in which the first and second conductive layers of the electrodes are used as masks.

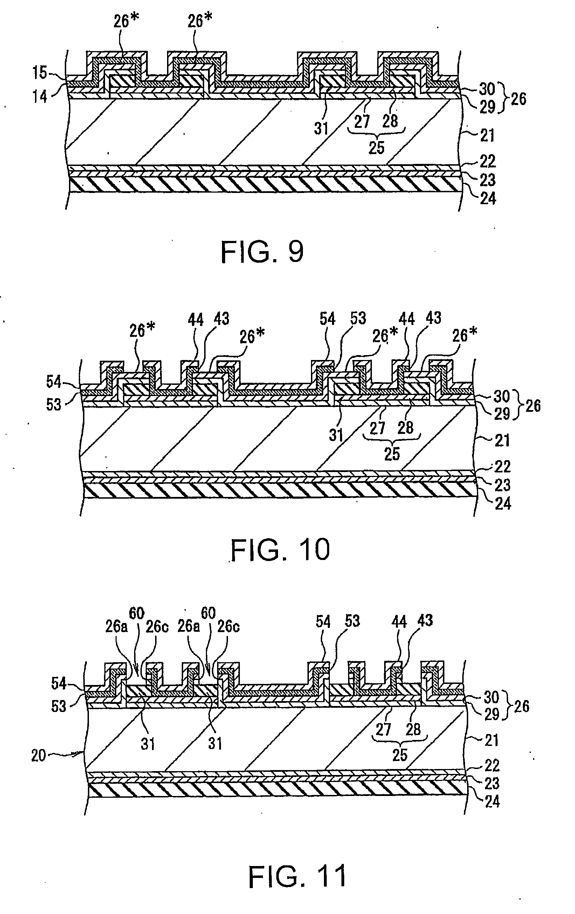

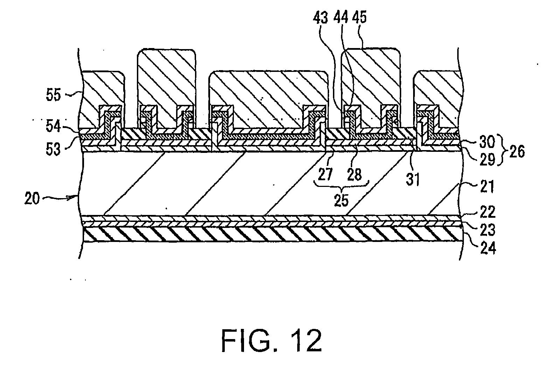

Next, with reference to FIGs. 5 - 12, a method of producing the photovoltaic device 10 will be exemplified. FIGs. 5 - 8 are diagrams showing production steps of an intermediate product 13 (photovoltaic unit 20 in which the separation gap 60 is not formed) . FIGs. 9 and 10 are diagrams showing formation steps of the first conductive layers 43 and 53 and the second conductive layers 44 and 54. FIG. 11 is a diagram showing a formation step of the separation gap 60. FIG. 12 is a diagram showing a formation step of the third conductive layers 45 and 55.

In the following, a step is exemplified in which the second conductive layers 44 and 54 forming the electrodes are set as seed layers and the third conductive layers 45 and 55 and the fourth conductive layers 46 and 56 are formed through electroplating. In addition, a step of forming the separation gap 60 using the second conductive layers 44 and 54 as a mask will be exemplified.

First, as shown in FIG. 5, for example, a clean n-type monocrystalline silicon substrate 21 is placed in a vacuum chamber, and the i-type amorphous silicon layer, the n-type amorphous silicon layer, and the insulating layer (protection layer) are layered in order, through plasma-enhanced chemical vapor deposition (PCVD) or sputtering. In the present embodiment, over one surface of the n-type monocrystalline silicon substrate 21, the i-type amorphous silicon layer 22, the n-type amorphous silicon layer 23, and the protection layer 24 are layered in order, and, over the other surface, the i-type amorphous silicon layer 27, the n-type amorphous silicon layer 28, and the insulating layer 31 are layered in order. In the following description, the one surface is referred to as a "light-receiving surface 11" and the other surface is referred to as a "back surface 12."

In the layering step of the i-type amorphous silicon films 22 and 27 by PECVD, for example, material gas obtained by diluting silane gas (SiH₄) by hydrogen (H₂) may be used. In the layering step of the n-type amorphous silicon films 23 and 28, for example, material gas obtained by adding phosphine (PH₃) into silane (SiH₄) and diluting with hydrogen (H₂) may be used. By changing the dilution percentage of the silane gas (SiH₄), the film characteristics of the i-type amorphous silicon films 22 and 27 and the n-type amorphous silicon films 23 and 28 can be changed. In addition, by changing a mixture concentration of phosphine (PH₃), doping concentrations of the n-type amorphous silicon films 23 and 28 can be changed.

It is preferable that, prior to the layering of the i-type amorphous silicon layer 22 or the like, a texture structure is formed over the light-receiving surface 11 of the n-type monocrystalline silicon substrate 21. The texture structure can be formed, for example, by applying anisotropic etching on the (100) plane using an etchant of potassium hydroxide (KOH).

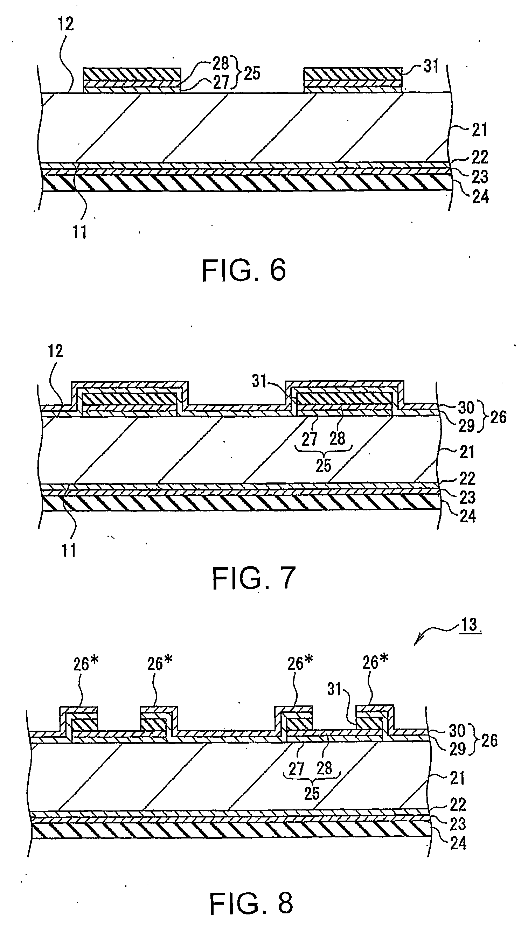

Next, as shown in FIG. 6, the layers which are layered over the back surface 12 are patterned. First, the insulating layer 31 is partially etched and removed. The region of the insulating layer 31 to be removed is a region over the back surface 12 where the IP layer 26 is to be layered in the later step. In the etching step of the insulating layer 31, for example, a resist film formed by a coating process using screen printing or an inkjet or through a photolithography process or the like is used as a mask. Specifically, the resist film is formed over the insulating layer 31 to be left. When the insulating layer 31 is silicon oxide (SiO₂), silicon nitride (SiN), or silicon oxynitride (SiON), for example, the insulating layer 31 can be etched using an etchant of hydrogen fluoride (HF).

After the etching of the insulating layer 31 is completed, for example, the resist film is removed, and the IN layer 25 which is exposed is etched using the patterned insulating layer 31 as a mask. The etching of the IN layer 25 is executed using an alkaline etchant such as, for example, an etchant of sodium hydroxide (NaOH) (for example, an etchant of NaOH of 1 wt%). Both the i-type amorphous silicon layer 27 and the n-type amorphous silicon layer 28 forming the IN layer 25 can be removed with the etchant of NaOH. With this step, the IN layer 25 and the insulating layer 31 which are patterned are formed over the back surface 12.

Alternatively, for the etching of the IN layer 25, the IP layer 26, and the insulating layer 31, for example, there may be used an etching paste or an etching ink in which the viscosity is adjusted. In this case, the etching paste is applied by screen printing or inkjet or the like over a region in which the IN layer 25 or the like is removed.

Next, as shown in FIG. 7, the IP layer 26 is layered, for example, over the entire region of the back surface 12 other than an end edge region. That is, the IP layer 26 is layered also over the patterned IN layer 25 with the insulating layer 31 therebetween. Similar to the IN layer 25, the IP layer 26 can be formed by forming in order the i-type amorphous silicon layer 2 9 and the p-type amorphous silicon layer 30 by PECVD. However, in the layering step of the p-type amorphous silicon layer 30, for example, diborane (B₂H₆) is used as the material gas in place of PH₃.

Then, as shown in FIG. 8, the IP layer 26 layered over the IN layer 25 is patterned and the insulating layer 31 is partially removed, to obtain the intermediate product 13. Although not shown in this drawing, the IN layer 25 and the IP layer 26 of the intermediate product 13 can be formed, for example, in a planar shape pattern of a comb-like shape in which the IN layer 25 and the IP layer 26 interdigitate each other. Alternatively, the electrode patterns maybe formed through screen printing or the like after the separation gap 60 is formed in the intermediate product 14. However, in consideration of the productivity and patterning precision or the like, it is preferable to form the separation gap 60 using the patterned seed layer as a mask.

In this step, first, the IP layer 26 layered over the IN layer 25 is partially etched and removed. The region of the IP layer 26 to be removed is the region over the IN layer 25 where the n-side electrode 40 is to be formed in the later step. In the etching step of the IP layer 26, for example, the resist film formed by the screen printing or the like is used as a mask, and an alkaline etchant such as an etchant of NaOH is used. Normally, because the IP layer 26 is harder to be etched than the IN layer 25, preferably, there is used an etchant of NaOH having a higher concentration than the etchant of NaOH for the IN layer 25 (for example, etchant of NaOH of 10 wt%) or a fluonitric acid (HF, HNO₃) (for example, each being 30 wt%). Alternatively, the etchant of NaOH may be preferably heated to about 70°C - 90°C (thermal alkaline process). A region protected by the formed resist film becomes the overlap region 26*.

After the etching of the IP layer 26 is completed, for example, the resist film is removed, and the insulating layer 31 which is exposed is etched and removed using the patterned IP layer 26 as a mask and using an etchant of HF. With the insulating layer 31 being removed, a part of the IN layer 25 is exposed.

Next, as shown in FIG. 9, the first conductive layer 14 and the second conductive layer 15 are formed in order over the exposed IN layer 25 and the patterned IP layer 26. The first conductive layer 14 and the second conductive layer 15 are preferably layered over the entire region over the IN layer 25 and the IP layer 26. The first conductive layer 14 is a layer which is patterned in a later step and forms the first conductive layers 43 and 53 of the electrodes, and the second conductive layer 15 is a layer which is patterned in a later step and forms the second conductive layers 44 and 54 of the electrodes.

The first conductive layer 14 is, for example, a transparent conductive layer such as ITO, and can be formed through sputtering or PECVD. The second conductive layer 15 is, for example, a metal layer such as a Cu layer, and can be formed through a method similar to that used to form the first conductive layer 11. As described above, the first conductive layer 14 can be formed with a thickness of about 50 nm - 100 nm. The second conductive layer 15 is preferably formed with a thickness of about 50 nm - 1 µm.

Then, as shown in FIG. 10, the first conductive layer 14 and the second conductive layer 15 are patterned to form the first conductive layers 43 and 53 and the second conductive layers 44 and 54. The first conductive layer 14 and the second conductive layer 15 can be etched, for example, using a resist mask formed by screenprinting or the like as amaskandusing an etchant containing ferric chloride (FeCl₃) and hydrochloric acid (HCl).

The regions of the first conductive layer 14 and the second conductive layer 15 to be etched are preferably regions directly above the overlap region 26*. In addition, it is particularly preferable that the region to be etched is a line-shaped region along the overlap region 26*. For example, the resist film is preferably formed over the entire region over the first conductive layer 14 and the second conductive layer 15 while leavinga line-shaped region along the overlap region 26*.

In this step, the distance between the conductive layers (the first conductive layer 43 and the second conductive layer 44) of the n-side electrode 40 and the conductive layers (the first conductive layer 53 and the second conductive layer 54) of the p-side electrode 50 can be controlled by, for example, adjusting the formation pattern of the resist film. The distance is preferably adjusted in consideration of the growth in the lateral direction of the third conductive layers 45 and 55 and the fourth conductive layers 46 and 56 which are formed in a later step, and is preferably about 200 µm, for example.

With this step, a part of the overlap region 26* of the IP layer 26 is exposed, but the IP layer 26 is not thinned. Therefore, a removal step of the IP layer 26 for forming the separation gap 60 (or thin film region) to be described next must be separately provided.

FIG. 11 shows the photovoltaic unit 20 in a state where the separation gap 60 is formed in the IP layer 26; that is, a state where the first conductive layers 43 and 53 and the second conductive layers 44 and 54 are formed on the back surface side.

As shown in FIG. 11, the overlap region 26* of the IP layer 26 is etched and removed, to form the separation gap 60 in the overlap region 26*. More specifically, after the etching of the first conductive layer 14 and the second conductive layer 15 is completed, for example, the resist film is removed, and the exposed IP layer 26 is etched using the first conductive layers 43 and 53 and the second conductive layers 44 and 54 as a mask. As described above, the etching of the IP layer 26 can be executed using a high-concentration etchant of NaOH or a thermal alkaline process.

With this step, the IP layer 26 in the exposed region is etched and removed, so that the overlap region 26* of the IP layer 26 can be separated into a region where the first conductive layer 53 and the second conductive layer 54 of the p-side electrode 50 are formed (for example, the above-described IP regions 26a and 26b) and a region where the first conductive layer 43 and the second conductive layer 44 of the n-side electrode 40 are formed (for example, the above-described IP region 26c).

In addition, in this step, the separation gap 60 is formed along the separation channel 61 by using the first conductive layers 43 and 53 and the second conductive layers 44 and 45 forming the electrodes as an etching mask. In other words, because the gap between the first conductive layer 43 (second conductive layer 44) and the first conductive layer 53 (second conductive layer 54) corresponds to the separation channel 61, the exposed overlap region 26* is removed along the region between the first conductive layer 43 and the first conductive layer 53, to form the separation gap 60 along the separation channel 61.

In addition, in this step, for example, the etching time and the concentration of the etchant can be adjusted, to leave a part of the IP layer 26. For example, the IP layer 26 may be not completely removed, and a region in which the p-type amorphous silicon layer 30 is thinned or a region where only the i-type amorphous silicon layer 29 is left may be formed between the IP regions 26a and 26b and the IP region 26c.

Alternatively, this step may be executed after the formation step of the third conductive layers 45 and 55. In this case, the distance between the third conductive layer 45 and the third conductive layer 55 may be set similar to the width of the separation gap 60. However, in consideration of productivity or the like, the separation gap 60 is preferably formed before formation of the third conductive layers 45 and 55.

Next, as shown in FIG. 12, the third conductive layers 45 and 55 are formed over the second conductive layers 44 and 54, respectively. The third conductive layers 45 and 55 may be formed through electroplating using the second conductive layers 44 and 54 as seed layered. Further, a metal layer such as, for example, an Sn layer, is formed by electroplating over the fourth conductive layers 46 and 56, to obtain the photovoltaic device 10 having the n-side electrode 40 and the p-side electrode 50 on the back surface side of the photovoltaic unit 20.

The electroplating can be executed, for example, by applying currents of the same magnitude to the second conductive layer 44 forming the n-side electrode 40 and the second conductive layer 54 forming the p-side electrode layer 50. In this case, metal-plated layers of the same mass are formed over the second conductive layers 44 and 54. Therefore, on the n-side electrode 40 having a smaller layering area than the p-side electrode 50, the thickness of the third conductive layer is thickened. That is, by applying the electroplating while the currents of the same magnitude are applied, it is possible to set the thickness of the n-side electrode 40 to be thicker than the thickness of the p-side electrode 50.

As described, in the photovoltaic device 10 of the present embodiment, the IN layer 25 and the IP layer 26 are layered, for example, over the entire region of the back surface of the n-type monocrystalline silicon substrate 21 other than the end edge region, with a part of the IP layer 26 overlapping with a part of the IN layer 25 and without a gap. Because of this, a part of the n-side electrode 40 is formed over the overlap region 26* of the IP layer 26. In the photovoltaic device 10, in the IP layer in which the n-side electrode 40 and the p-side electrode 50 are formed, there is provided a separation gap 60 which separates a region where the n-side electrode 40 is formed and a region where the p-side electrode 50 is formed. Therefore, the insulation in the lateral direction of the IP layer 26 is improved, and leak current can be reduced. In the photovoltaic device 10, in a structure having no electrode on the light-receiving surface side and having a high light-receiving efficiency, leakcurrent is reduced, and, consequently, photovoltaic efficiency is further improved.

In addition, in the photovoltaic device 10, the IP layer 26 is layered over the IN layer 25 with the insulating layer 31 therebetween. With such a structure, the insulation between the IN layer 25 and the IP layer 26 can be improved, and leak current can be further reduced. In addition, because the insulating layer 31 is provided, the layer which is exposed when the separation gap 60 is formed over the overlap region 26* is the insulating layer 31. In other words, even when the separation gap 60 is formed, the IN layer 25 is not exposed.

Moreover, in the photovoltaic device 10, for example, the separation channel 61 which separates the n-side electrode 40 and the p-side electrode 50 is formed directly above the overlap region 26*, and the separation gap 60 is formed along the separation channel 61. With such a structure, the IP layer 26 which connects the n-side electrode 40 and the p-side electrode 50 can be completely partitioned between the electrodes. Because of this, the insulation between the IN layer 25 and the n-side electrode 40 and the IP layer 26 and the p-side electrode 50 can be further improved and leak current can be significantly reduced.

The present embodiment may be modified in design within a range of not losing the advantage of the present invention. For example, in the present embodiment, there is described a configuration in which the IP layer 26 is layered overlapping the IN layer 25, but alternatively, there may be employed a configuration in which the IN layer 25 is layered overlapping the IP layer 26. In this case, the separation gap which separates the region where the n-side electrode 40 is formed and the region where the p-side electrode 50 is formed is preferably formed in the IN layer 25.

### [Explanation of Reference Numerals]

10 PHOTOVOLTAIC DEVICE; 11 LIGHT-RECEIVING SURFACE; 12 BACK SURFACE; 13 INTERMEDIATE PRODUCT; 14 FIRST CONDUCTIVE LAYER; 15 SECOND CONDUCTIVE LAYER; 20 PHOTOVOLTAIC UNIT; 21 n-TYPE MONOCRYSTALLINE SILICON SUBSTRATE; 22, 27, 29 i-TYPE AMORPHOUS SILICON LAYER; 23, 28 n-TYPE AMORPHOUS SILICON LAYER; 24 PROTECTION LAYER; 25 IN AMORPHOUS SILICON LAYER (IN LAYER); 26 IP AMORPHOUS SILICON LAYER (IP LAYER) ; 30 p-TYPE AMORPHOUS SILICON LAYER; 31 INSULATING LAYER; 40 n-SIDE ELECTRODE; 41, 51 FINGER ELECTRODE SECTION; 42, 52 BUS BAR ELECTRODE SECTION; 43, 53 FIRST CONDUCTIVE LAYER; 44, 54 SECOND CONDUCTIVE LAYER; 45, 55 THIRD CONDUCTIVE LAYER; 46, 56 FOURTH CONDUCTIVE LAYER; 50 p-SIDE ELECTRODE; 60 SEPARATION GAP; 61 SEPARATION CHANNEL

## Claims

1. A photovoltaic device, comprising:
a crystalline semiconductor substrate;
a first amorphous semiconductor layer which is layered over one surface of the crystalline semiconductor substrate;
a second amorphous semiconductor layer which includes a layer of an opposite conductive type as that of the first amorphous semiconductor layer, the second amorphous layer being layered over a region of the one surface of the crystalline semiconductor substrate where the first amorphous semiconductor layer is not layered, and the second amorphous layer being layered so as to have an overlap region which is overlapped with the region where the first amorphous semiconductor layer is layered ; a first electrode which is electrically connected to the first amorphous semiconductor layer and which is formed over the overlap region of the second amorphous semiconductor layer; and
a second electrode which is formed distanced from the first electrode and electrically connected to the second amorphous semiconductor layer, wherein
the second amorphous semiconductor layer has a separation gap or a thin film region where a thickness is thinner than other regions, between a region where the first electrode is formed and a region where the second electrode is formed.

2. The photovoltaic device according to Claim 1, wherein
the second amorphous semiconductor layer is layered over the first amorphous semiconductor layer with an insulating layer therebetween.

3. The photovoltaic device according to Claim 1 or 2, wherein
a separation channel which separates the first electrode and the second electrode is formed in the overlap region.

4. The photovoltaic device according to Claim 3, wherein
the separation gap or the thin film region is formed along the separation channel.

5. A method of producing a photovoltaic device, comprising:
a step of layering a first amorphous semiconductor layer over one surface of a crystalline semiconductor substrate;
a step of layering a second amorphous semiconductor layer over a region, of the one surface of the crystalline semiconductor substrate, where the first amorphous semiconductor layer is not layered, and over a part of a region where the first amorphous semiconductor layer is layered, the second amorphous semiconductor layer including a layer of an opposite conductive type as that of the first amorphous semiconductor layer;
an electrode forming step in which a first electrode is formed over the first amorphous semiconductor layer and over an overlap region of the second amorphous semiconductor layer overlapped with the first amorphous semiconductor layer, and a second electrode is formed over the second amorphous semiconductor layer distanced from the first electrode; and
a removal step in which at least a part of the second amorphous semiconductor layer which exists between the first electrode and the second electrode is removed.

6. The method of producing the photovoltaic device according to Claim 5, further comprising:
a step of layering an insulating layer over a part of the first amorphous semiconductor layer, wherein
in the step of layering the second amorphous semiconductor layer, the second amorphous semiconductor layer is layered over the first amorphous semiconductor layer with the insulating layer therebetween.

7. The method of producing the photovoltaic device according to Claim 5 or 6, wherein
the electrode forming step comprises:
a step of forming, over the first amorphous semiconductor layer and the second amorphous semiconductor layer, at least one conductive layer forming the first electrode and the second electrode; and
a step of partially removing the conductive layer in the overlap region of the second amorphous semiconductor layer to separate the conductive layer into a first electrode conductive layer forming the first electrode and a second electrode conductive layer forming the second electrode.

8. The method of producing the photovoltaic device according to Claim 7, wherein
in the removal step, at least a part of the overlap region of the second amorphous semiconductor layer which is exposed is removed using the first electrode conductive layer and the second electrode conductive layer as a mask.

9. The method of producing the photovoltaic device according to Claim 8, wherein
in the removal step, the overlap region of the second amorphous semiconductor layer which is exposed is removed along a regionbetween the first electrode conductive layer and the second electrode conductive layer.

10. The method of producing the photovoltaic device according to Claim 8 or 9, wherein
the electrode forming step further includes a step of forming, through electroplating which uses the first electrode conductive layer and the second electrode conductive layer as seeds, metal-plating layers over the seeds, after the removal step.
